# EUROPÄISCHE PATENTSCHRIFT

(11) **EP 0 544 983 B1**
(45) Veröffentlichungstag und Bekanntmachung des Hinweises auf die Patenterteilung: **26.11.1997**
(21) Anmeldenummer: 92111056.5
(22) Anmeldetag: 30.06.1992
(51) Int. Cl.: H01L 31/18, H01L 27/142, H01L 31/0224

(54) **Dünne Solarzelle und Verfahren zu ihrer Herstellung**
Thin solar cell and its production method
Cellule solaire mince et son procédé de fabrication

(30) Priorität: 04.10.1991 DE 4132903
(43) Veröffentlichungstag der Anmeldung: 09.06.1993
(73) Patentinhaber: Daimler-Benz Aerospace Aktiengesellschaft, 81663 München (DE)
(72) Erfinder: Hilgarth, Just, Dipl.-Phys., W-7129 Ilsfeld (DE); Frese, Volker, Dipl.-Phys., W-7100 Heilbronn (DE); Braun, Matthias, Dipl.-Phys., W-7100 Heilbronn (DE)
(74) Vertreter: Frick, Gerhard, Dipl.-Ing.

(56) Entgegenhaltungen:
- EP-A- 0 232 749
- DE-A- 3 900 254
- US-A- 3 527 619
- US-A- 4 746 618
- US-A- 5 021 099
- PATENT ABSTRACTS OF JAPAN vol. 10, no. 285 (E-441)(2341) 27. September 1986 & JP-A-61 105 876

## Beschreibung

Die Erfindung betrifft eine dünne Solarzelle gemäß dem Oberbegriff von Anspruch 1 und ein Verfahren zur Herstellung der Solarzelle, gemäß Anspruch 9.

Dünne Solarzellen mit hohem Wirkungsgrad sind zur Zeit weltweit Ziel der Entwicklung, da das Verhältnis Leistung zu Gewicht für eine Anwendung in Satellitten von entscheidender Bedeutung ist. Bei Solarzellen, die aus einem direkten Halbleitermaterial bestehen, erfolgt z. B die Lichtabsorption innerhalb weniger µm. Direkte Halbleiter von wenigen µm Dicke können somit elektrisch die volle Funktion einer Solarzelle übernehmen. Beispielsweise zeichnen sich Solarzellen aus GaAs (einem direkten Halbleitermaterial) gegenüber Solarzellen aus Silizium, bei dem als indirektem Halbleiter die vollständige Lichtabsorption eine Schicht von ca. 70 µm erfordert, durch höhere Wirkungsgrade und bessere Strahlungsresistenz aus. Die Anwendung von Solarzellen aus GaAs liegt daher häuptsächlich im Bereich niederorbitaler Satellitten. Der Nachteil von GaAs gegenüber Si liegt in dem wesentlich höheren Gewicht von Zellen bei etwa gleicher Dicke wie Si-Zellen.

Die gesamten lichtelektrisch empfindlichen Schichten werden bei einer GaAs-Solarzelle ebenso wie bei Solarzellen, die aus Halbleitern der III-V oder II-VI Gruppe des Periodensystems bestehen, in einem Epitaxieverfahren (Aufwachsen mehrerer unterschiedlich dotierter und zusammengesetzter kristalliner Schichten auf einem Trägersubstrat) hergestellt. Das Substrat, auf dem die photoaktiven Schichten entstehen, hat i. a. keine lichtelektrische Funktion und dient meist nur zur Erzeugung dieser Schichten und zur Stabilität des Halbleiterkörpers. Es ist möglich, die in der lichtelektrischen Funktion meist unnötige und durch ihr Gewicht (gerade bei Anwendung in Satellitten) störenden Schichten vor Inbetriebnahme der Solarzellen ganz oder teilweise zu entfernen. Hierzu bieten GaAs und andere Verbindungshalbleiter, bei denen die photoelektrischen Schichten im epitaktischen Verfahren hergestellt werden, besondere Möglichkeiten die Substratschicht zur Herstellung dünner Halbleiterschichten von der Epitaxie zu trennen:
1. CLEFT-Prozeß für Epitaxieschichten
2. Abhebetechnik über eine chemisch selektiv ätzbare epitaktisch gewachsene Zwischenschicht
3. Ätztechnik mit Abätzen des Substrats bis zu einer epitaktisch gewachsenen Stop-Schicht

Abpolieren des Substrats bis zu den photoelektrisch aktiven Schichtbereichen. Abläppen und/oder -poliern und/oder chemisch -ätzen ganz oder nahezu bis zu den photoeletrisch aktiven Schichtbereichen ist auch bei nicht in epitaktischen Verfahren hergestellten Schichten anwendbar.

Die vollständige oder teilweise Entfernung des Substrats ist jedoch nicht notwendiger Teil der Erfindung. Als dünne Solarzelle ist auch eine Zelle anzusehen, bei der der Halbleiterkörper aufgrund seiner geringen Dicke und dadurch bedingter Zerbrechlichkeit allein ohne stabilisierenden Träger nicht mehr ausreichend handhabbar ist. Die zur Verschaltung der Solarzellen notwendige Anbringung von Verbindern an Verschaltungspunkte auf dem dünnen Halbleiterkörper durch Bonden, Löten oder sonstige thermisch oder mechanisch belastende Prozesse ist wegen der dadurch bedingten Bruchgefahr kaum mehr möglich.

Der P/N-Übergang der meisten Halbleiter und bei direkten Halbleitern meist auch die zur Reduzierung der sonst sehr hohen Oberflächenrekombination notwendige sog. Fensterschicht (z. B. AlGaAs bei GaAs-Solarzellen) sind gegen Umwelteinflüsse empfindlich. Die Ränder der Solarzellen aus GaAs und der meisten anderen Solarzellen aus direktem Halbleitermaterial müssen daher, zumindest solange sie diesen Einflüssen ausgesetzt sind, speziell geschützt (passiviert) werden. Bei GaAs-Solarzellen z. B. erfolgt dies meist durch Ätzen eines "Mesa"-Grabens um die aktive Fläche von der Vorderseite durch die lichtaktive Schicht mit anschließender Passivierung durch ein Dielektrium (z. B. der Antireflexschicht) und Absägen des Randes. Dieser Schritt beinhaltet eine Solarzellen-Flächen-Definition, durch die die Größe der lichtelektrisch aktiven Fläche der Solarzelle festgelegt wird.

Eine dünne Solarzelle der eingangs genannten Art ist aus der US 3,527,619 bekannt. Bei dieser sind die Verschaltungspunkte jeweils an den Ecken der dem Lichteinfall zugekehrten Vorderseite der Zelle angeordnet. Nach der Verschaltung werden auf den Zellenverband separate Deckgläser aufgeklebt, und zwar entweder großflächig oder unter Freilassung der jeweiligen Verschaltungspunkte. Weitere einschlägige Solarzellen sind aus der US 5,017,243 sowie der EP 0 421 133 A2 bekannt.

Der Erfindung liegt die Aufgabe zugrunde, eine dünne Solarzelle der eingangs genannten Art zu schaffen, die trotz ihrer geringen Dicke und damit verbundenen verhältnismäßig leichten Zerbrechlichkeit eine einwandfreie und sichere Verschaltung zu großflächigen und leichten Solarmodulen ermöglicht, wobei insbesondere auf die stabile Anbringung der Verbinder ohne Gefahr der Beschädigung des empfindlichen Halbleiterkörpers zu achten ist.

Diese Aufgabe ist erfindungsgemäß durch den Anspruch 1 gelöst.

Weitere erfindungsgemäße Ausgestaltungen sind in den Unteransprüchen 2 bis 8 beschrieben.

Verfahren zur Herstellung der erfindungsgemäßen Solarzellen sind in den Unteransprüchen 9 und 15 beansprucht.

Erfindungsgemäße Weiterbildungen der Verfahren sind in den Unteransprüchen 10 bis 14 sowie 16 und 17 beschrieben.

In der Zeichnung ist ein Ausführungsbeispiel nach der Erfindung dargestellt, und zwar zeigen:
- Fig. 1: eine von beiden Seiten lichtempfindliche Solarzelle (Bi-facial-Zelle) im Schnitt (Verschaltungskörper direkt auf dem Deckglas der Vorderseite),
- Fig. 2: vier Abbildungen, die einzelne Verfahrensschritte zur Herstellung einer Solarzelle verdeutlichen,
- Fig. 3: eine serielle Schaltung von vier Solarzellen,
- Fig. 4: eine parallele Schaltung von vier Solarzellen und
- Fig. 5: eine Solarzelle mit einem Grid-Design zur seriellen und parallelen Verschaltung.

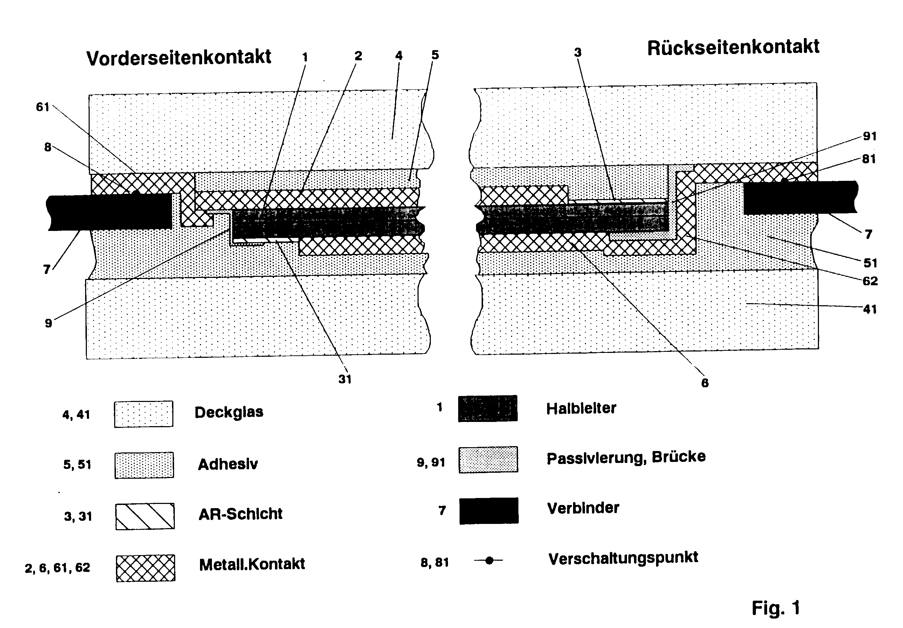

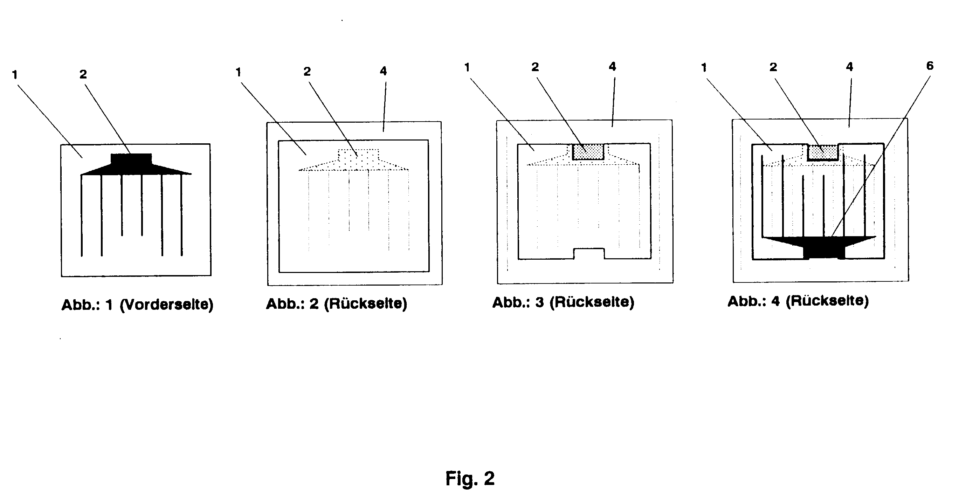

In Fig. 1 ist eine dünne Solarzelle, vorzugsweise eine Galliumarsenid-Zelle, mit einem aus direktem Halbleitermaterial bestehenden Halbleiterkörper 1 dargestellt, der auf seiner vorderseitigen Lichteinfallseite ein gridförmiges Kontaktsystem 2, eine Antireflex-Schicht 3 und ein Deckglas 4 aufweist. Das Deckglas 4 ist mittels eines temperaturbeständigen Klebers 5 befestigt, um eine eventuell erforderliche Sinterung des Rückseitenkontaktes 6 zum Halbleiterkörper 1 zu ermöglichen. Möglich ist auch die Anbringung des Deckglases 4 durch direktes Anschmelzen (direct glasing). Diese Befestigungsmöglichkeiten gelten auch für das rückseitige Deckglas 41.

Um jeweils einen Solarzellen-Verbinder 7 zur Herstellung einer Serien- und/oder Parallelverbindung von mehreren Solarzellen an den Vorderseiten- und Rückseitenkontakt 2 bzw. 6 anschließen zu können, befinden sich auf der dem Halbleiterkörper 1 zugewandten Seite der Kleberschicht 5 bzw. des Deckglases 4 zwei Verschaltungspunkte 8 und 81, an die die Solarzellen-Verbinder 7 elektrisch angeschlossen sind, und die beispielweise über Brückenkontakte (s. u.) mit dem Vorder- und Rückseitenkontakt 2 und 6 elektrisch leitend verbunden sind. Eine einfache Verbindung zwischen den Verbindungspunkten 8 und 81 und den Kontakten 2 und 6 wird dadurch erzielt, daß der Vorderseitenkontakt 2 einen Kontaktbalken aufweist und der Rückseitenkontakt 6 an der Stirnfläche des Halbleiterkörpers 1 vorbei zum Deckglas 4 verläuft, wobei zwischen der Stirnseite des Halbleiters 1 und dem unmittelbar benachbarten Kontaktstück eine Isolierschicht 91 angeordnet sein muß (Brückenkontakt 62). Hierbei kann es sich vorteilhafterweise um ein zur Passivierung der Stirnseite des Halbleiterkörpers 1 dienendes Dielektrium 9 handeln. Falls z. B. eine Passivierung der Stirnseite nicht erforderlich sein sollte, ist auch eine Brücke über Luft oder Vakuum möglich (Luftbrückenkontakt).

Die bisher beschriebene Solarzelle stellt praktisch eine einfache Solarzelle mit einer einseitigen lichtempfindlichen Oberfläche dar. Zur Schaffung einer Bi-facial-Solarzelle mit zwei gegenüberliegenden lichtempfindlichen Seiten ist zunächst eine entsprechende geeignete Epitaxie-Schichtfolge erforderlich. Weiterhin weist eine derartige Solarzelle gemäß Fig. 1 ein als gridförmiges Kontaktsystem ausgebildeten Rückseitenkontakt 6, eine Antireflex-Schicht 31 und ein mit Kleberschicht 51 befestigtes Deckglas 41 auf.

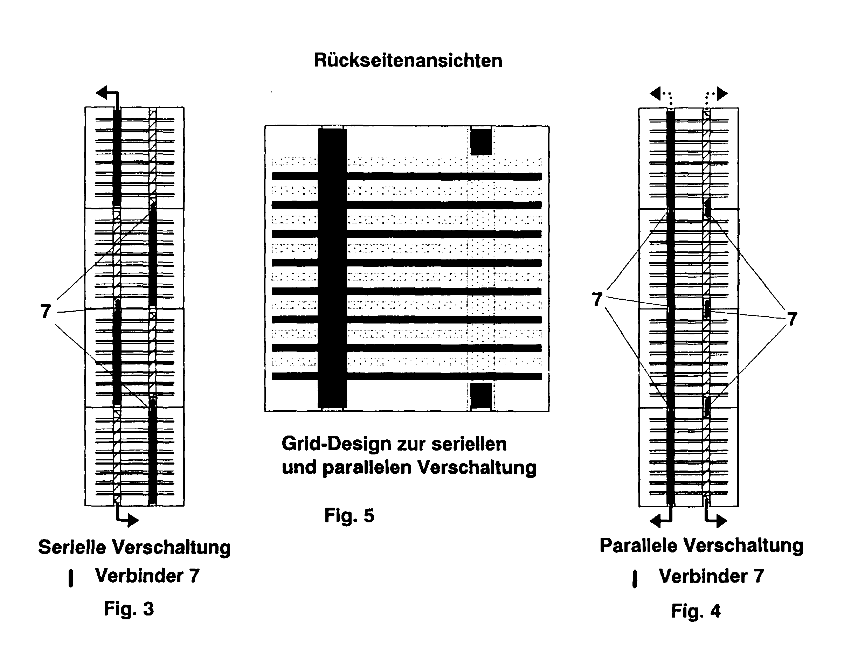

Die Herstellung einer obenbeschriebenen Solarzelle wird anhand der Abbildungen 1 bis 4 aus Fig. 2 und Fig. 1 beschrieben. Zunächst wird auf einem Trägersubstrat eine als Solarzelle verwendbare Schichtenfolge (Halbleiterkörper aus Halbleitermaterial) mit den je nach späterem Trennprozeß erforderlichen Zwischenschichten aufgebracht. Auf die vorderseitige Lichteinfallsseite des Halbleiterkörpers 1 werden ein gridförmiges Kontaktsystem 2 mit Anschlußkontaktbalken und eine Antireflex-Schicht 3 aufgebracht (Fig. 2, Abb. 1). Die vorderseitige Lichteinfallsseite des Halbleiterkörpers 1 wird zusammen mit dem Kontaktsystem 2 und der Antireflex-Schicht 3 durch ein Deckglas 4 abgedeckt (Fig. 2, Abb. 2). Anschließend werden das Trägersubstrat ganz oder teilweise und gegebenenfalls vorhandene Zwischenschichten von dem Halbleiterkörper 1 entfernt. Hierzu können die eingangs beschriebenen vier Verfahren herangezogen werden. Diesem Verfahrensschritt schließt sich z. B. ein Ätzvorgang an, durch den die Ränder des Halbleiterkörpers 1 und gleichzeitig zwei Teilbereiche des Halbleiterkörpers 1 zur Freilegung eines auf dem Vorderseitenkontakt 2 liegenden Verbindungspunktes 8 und zur Schaffung einer Ausnehmung für den rückseitigen Verschaltungspunkt 81 weggeätzt werden (Fig. 2, Abb. 3). Auf die vom Trägersubstrat und gegebenfalls von Zwischenschichten befreite Rückseite des Halbleiterkörpers 1 wird der Rückseitenkontakt 6 aufgebracht, der sich durch die Ausnehmung für den rückseitigen Verbindungspunkt 81, gegenüber der Stirnseite des Halbleiterkörpers 1 isoliert (62), bis auf die dem Halbleiterkörper 1 zugewandten Seite des Deckglases 4 oder bis auf eine zwischen Deckglas 4 und Halbleiterkörper 1 befindliche Kleberschicht 5 erstreckt und dort den Verschaltungspunkt 81 für den Rückseitenkontakt 6 bildet (Fig. 2, Abb.4). Bei der Herstellung des Rückseitenkontakts 6, oder Brücke 62 und des Verschaltungspunktes 81 auf der dem Halbleiterkörper zugewandten Seite des Deckglases 4 kann durch Vergrößerung des VorderseitenKontaktbalkens auch ein Verschaltungskörper 61 für den Verschaltungspunkt 8 direkt auf dem Deckglas hergestellt werden (Fig. 1: Vorderseitenkontakt). Abschließend werden an die mit dem Vorderseitenkontakt 2 und mit dem Rückseitenkontakt 6 in elektrisch leitender Verbindung stehenden Verschaltungspunkte 8 und 81 die Solarzellen-Verbinder 7 angeschlossen.

Von Vorteil ist, daß sich beide Verschaltungspunkte 8 und 81 erfindungsgemäß auf der Deckglasrückseite (Solarzellen-Seite) befinden. Sie können außerhalb, innerhalb oder am Rand des als Solarzellenfläche definierten Bereichs angebracht werden. Bei Anbringung der Verschaltungspunkte am Solarzellen-Rand ist eine Verschaltung der Solarzellen miteinander besonders einfach und nahezu ohne Zwischenraum zwischen den lichtaktiven Flächen der Zellen möglich. Durch die Verschaltungspunkte 8 der Vorderseitenkontakte entsteht kein zusätzlicher Verlust an aktiver Solarzellen-Fläche, und der zusätzliche Verlust an aktiver Solarzellen-Fläche durch die Verschaltungspunkte 81 der Rückseitenkontakte ist gering und kann bei geeignetem Design unter 2 % der Gesamtfläche gehalten werden. Die Lage der Verschaltungskörper der Verschaltungspunkte vom Halbleiterkörper entfernt auf dem Deckglas oder einer Zwischenschicht erlaubt die stabile Anbringung der Verbinder ohne Gefahr der Beschädigung des empfindlichen Halbleiterkörpers.

Ein weiterer Vorteil der Erfindung ist darin zu sehen, daß in einem Arbeitsschritt die Abätzung der Ränder (Solarzellen-Flächen-Definition), die Öffnung des vorderen Verschaltungspunktes und die Freiätzung einer Stelle für den rückseitigen Verschaltungspunkt durchgeführt wird. Auch die bei einem Trennprozeß möglicherweise auftretenden Beschädigungen des Halbleiter-Randes (Unterätzung, Ausbrüche, etc.) werden dabei durch das Ätzen eliminiert. Da bei Epitaxien die Schichten in einem Streifen von ca. 1-2 mm am Substratrand nicht in der gleichen Qualität aufwachsen wie sonst auf dem Halbleiter (Kurzschlüsse), muß das Substrat zu Beginn der Herstellung um diesen Betrag größer gewählt werden als die spätere lichtelektrisch aktive Solarzellen-Fläche. Die Erfindung macht sich das zunutze; bei der Verarbeitung ganzer epitaxierter Wafer zu einer einzigen Solarzelle trägt dieser für die Herstellung qualitativ guter Solarzellen notwendige Randstreifen zur sicheren Handhabung bei, ist jedoch nicht notwendiger Teil der Erfindung; Ränder von wenigen µm Breite reichen aus.

Es ist möglich, daß vor dem Aufbringen des Rückseitenkontaktes 6 die durch Ätzung hergestellten Ränder (Stirnseiten) des Halbleiterkörper 1 passiviert werden, beispielsweise durch Photolacke, Polyimide, Nitride, Oxide, die rückseitige Antireflexschicht (Bi-facial-Zelle) oder andere dielektrische Materialien; diese Passivierung kann dann auch als Isolierung 9 für den Brückenkontakt dienen.

Für die Herstellung einer Bi-facial-Solarzelle sind noch folgende zusätzliche Verfahrensschritte durchzuführen:
- auf das Trägersubstrat wird eine als Bi-facial-Solarzelle verwendbare Schichtenfolge aufgebracht,
- auf die vom Trägersubstrat und gegenfalls vorhandenen Zwischenschichten befreite Rückseite wird ein gridförmiges Rückseitenkontaktsystem 6 und eine Antireflex-Schicht 31 aufgebracht
- auf die Rückseite der Solarzelle wird ein Deckglas 41 aufgebracht.

Aufgrund dessen, daß sich die Vorder- und Rückseitenverschaltungspunkte auf derselben Seite des Deckglases befinden, ist es sehr einfach und ohne Änderung des Prozesses und des Grid-Designs möglich, mit einem speziellen Grid-Design eine Solarzelle sowohl zur seriellen und parallelen Verschaltung so herzustellen, daß nahezu kein Verlust an aktiver Fläche durch das Verschalten dieser Zellen untereinander auftritt und nahezu kein Zwischenraum zwischen den aktiven Flächen entsteht. Entsprechende Beispiele sind aus den Fig. 3 bis 5 ersichtlich.

## Patentansprüche

1. Dünne Solarzelle mit einem aus photoaktiven Halbleiterschichten bestehenden Halbleiterkörper, der auf seiner vorderseitigen Lichteinfallseite ein gridförmiges Kontaktsystem als Vorderseitenkontakt und ein Deckglas (4,41) sowie auf seiner Rückseite einen Rückseitenkontakt (6) aufweist, wobei zum Anschluß von eine Serien- und/oder Parallelverbindung von mehreren Solarzellen ermöglichenden Solarzellen-Verbindern (7) zwei Verschaltungspunkte vorgesehen sind, von denen einer mit dem Vorderseitenkontakt und der andere mit dem Rückseitenkontakt in elektrisch leitender Verbindung steht, **dadurch gekennzeichnet,** daß die Verschaltungspunkte (8, 81) auf der dem Halbleiterkörper (1) zugewandten Rückseite des Deckglases (4) jeweils an einander gegenüberliegenden Rändern des als Solarzellenfläche definierten Bereiches in vom Halbleiterkörper (1) freien Zonen angeordnet sind, und daß die Vorderseite des Halbleiterkörpers eine Antireflex-Schicht (3,31) aufweist.

2. Solarzelle nach Anspruch 1, **dadurch gekennzeichnet,** daß die Verschaltungspunkte (8, 81) sich auf einer dielektrischen Zwischenschicht (5) zwischen Deckglas (4) und Halbleiterkörper (1) befinden.

3. Solarzelle nach Anspruch 2, dadurch gekennzeichnet, daß als Zwischenschicht eine Kleberschicht (5) zwischen Deckglas (4) und Halbleiterkörper (1) dient.

4. Solarzelle nach Anspruch 2, gekennzeichnet durch die als Zwischenschicht dienende Antireflex-Schicht (3, 31).

5. Solarzelle nach Anspruch 1 oder 2, dadurch gekennzeichnet, daß die elektrischen Verbindungen zwischen den Kontakten (2, 6) und zugehörigen Verschaltungspunkten (8, 81) durch Brückenkontakte hergestellt sind.

6. Solarzelle nach Anspruch 5, gekennzeichnet durch eine Isolierschicht zwischen dem Halbleiterkörper (1) und dem den Verschaltungsspunkt (81) mit dem Rückseitenkontakt (6) verbindenen Brückenkontakt (62).

7. Solarzelle nach Anspruch 1, 2, 3, oder 6, dadurch gekennzeichnet, daß die Stirnseite des Halbleiterkörpers (1) durch ein Dielektrikum (9) passiviert ist.

8. Solarzelle nach einem der Ansprüche 1 bis 7, dadurch gekennzeichnet, daß der Halbleiterkörper (1) eine zur Schaffung einer von zwei Seiten lichtempfindlichen Solarzelle dienenden Halbleiter-Schichtenfolge aufweist, daß der Rückseitenkontakt (6) als grid-förmiges Kontaktsystem ausgebildet ist, und daß die Solarzelle auf ihrer Rückseite mit einer Antireflex-Schicht (31) und einem Deckglas (41) versehen ist.

9. Verfahren zur Herstellung einer Solarzelle nach einem der Ansprüche 1 bis 7, gekennzeichnet durch folgende Verfahrensschritte:
a) auf einem Trägersubstrat wird eine als Solarzelle verwendbare photoaktive Schichtenfolge als Halbleiterkörper hergestellt,
b) auf die vorderseitige Lichteinfallseite des Halbleiterkörpers (1) werden ein gridförmiges Kontaktsystem (2) mit Anschlußkontaktbalken und eine Antireflex-Schicht (3) aufgebracht,
c) die vorderseitige Lichteinfallseite des Halbleiterkörpers (1) wird zusammen mit dem Kontaktsystem (2) und der Antireflex-Schicht (3) durch ein Deckglas (4) abgedeckt ,
d) das Trägersubstrat und gegebenenfalls vorhandene Zwischenschichten werden ganz oder teilweise von dem Halbleiterkörper (1) entfernt,
e) durch einen Prozeß werden die Ränder des Halbleiterkörpers (1) und gleichzeitig zwei Teilbereiche des Halbleiterkörpers (1) zur Freilegung zumindest eines Teils des Vorderseitenkontakts (2) und zur Schaffung einer Ausnehmung für den rückseitigen Verschaltungspunkt (81) entfernt
f) auf die vom Trägersubstrat ganz oder teilweise und gegebenfalls von Zwischenschichten befreite Rückseite des Halbleiterkörpers (1) wird der Rückseitenkontakt (6) aufgebracht, der sich durch die Ausnehmung für den rückseitigen Verschaltungspunkt, gegenüber der Stirnseite des Halbleiterkörpers (1) isoliert, bis auf die dem Halbleiterkörper (1) zugewandten Seite des Deckglases (4) bzw. bis auf eine zwischen Deckglas (4) und Halbleiterkörper (1) befindliche dielektrische Zwischenschicht (5) erstreckt und dort den Verschaltungspunkt (81) für den Rückseitenkontakt bildet.

10. Verfahren nach Anspruch 9, dadurch gekennzeichnet, daß die nach Verfahrensschritt e) hergestellten Stirnseiten des Halbleiterkörpers (1) passiviert werden.

11. Verfahren nach Anspruch 9, dadurch gekennzeichnet, daß zur Entfernung des Trägersubstrates und gegebenenfalls vorhandener Zwischen- und Epitaxieschichten der an sich bekannte CLEFT-Prozeß verwendet wird.

12. Verfahren nach Anspruch 9, dadurch gekennzeichnet, daß das Trägersubstrat und gegebenenfalls vorhandene Zwischen- und Epitaxieschichten mittels Abhebetechnik über eine chemisch selektiv ätzbare epitaktisch gewachsene Zwischenschicht von dem Halbleiterkörper (1) entfernt werden.

13. Verfahren nach Anspruch 9, gekennzeichnet durch eine Ätztechnik mit Abätzen des Trägersubstrates und gegebenenfalls vorhandener Zwischen- und Epitaxieschichten bis zu einer epitaktisch gewachsenen Stop-Schicht.

14. Verfahren nach Anspruch 9, dadurch gekennzeichnet, daß das Trägersubstrat und gegebenfalls vorhandene Zwischenschichten ganz oder teilweise von dem Halbleiterkörper (1) durch Abläppen und/oder -polieren und/oder -ätzen ganz oder nahezu bis zu den photoelektrisch aktiven Schichtbereichen entfernt werden.

15. Verfahren zur Herstellung einer Solarzelle nach Anspruch 8 unter Durchführung der Verfahrensschritte nach Anspruch 9, 10, 11, 12, 13 oder 14, dadurch gekennzeichnet, daß auf das Trägersubstrat eine als Bi-facial-Solarzelle verwendbare Epitaxie-Schichtenfolge aufgebracht wird, daß auf die vom Trägersubstrat und gegebenenfalls vorhandenen Zwischenschichten befreite Rückseite ein gridförmiges Rückseitenkontaktsystem (6) und eine Antireflex-Schicht (31) aufgebracht werden, und daß auf die Rückseite der Solarzelle ein Deckglas (41) aufgebracht wird.

16. Verfahren nach Anspruch 9 oder 15, dadurch gekennzeichnet, daß das Deckglas (4, 41) mittels eines temperaturbeständigen Deckglasklebers (5, 51) aufgebracht wird.

17. Verfahren nach Anspruch 9 oder 15, gekennzeichnet durch ein direktes Anschmelzen des Deckglases (4, 41) auf die Solarzelle.

## Claims

1. Thin solar cell with a semi-conductor element composed of photo-active semi-conductor layers comprising at its front side of light incidence a gridshaped contact system as a front side contact and a cover glass (4, 41) as well on its rear a rear contact (6), and, for the purpose of connecting solar-cell connectors (17) which facilitate a series and/or parallel connection of a plurality of solar cells, circuit points are provided of which one is electrically connected to the front contact and the other to the rear contact, **characterised in that** the circuit points (8, 81) at the rear of the cover glass (4) facing towards the semi-conductor element (1) are arranged at opposing edges of the area defined as solar-cell surface in zones which are free of semi-conductor bodies (1), and the front of the semi-conductor element comprises an anti-reflex layer (3, 31).

2. Solar cell according to Claim 1 **characterised in that** the circuit points (8, 81) are positioned on a dielectric intermediate layer (5) between cover glass (4) and semi-conductor element (1).

3. Solar cell according to Claim 2, **characterised in that** an adhesive layer (5) between cover glass (4) and semi-conductor element (1) serves as an intermediate layer.

4. Solar cell according to Claim 2, **characterised by** an anti-reflex layer (3, 31) serving as an intermediate layer.

5. Solar cell according to Claim 1 or 2, **characterised in that** the electrical connections between the contacts (2, 6) and associated circuit points (8, 81) are established by means of bridge contacts.

6. Solar cell according to Claim 5, **characterised by** an insulating layer between the semi-conductor element (1) and the bridge contact (62) which connects the circuit point (81) to the rear contact (6).

7. Solar cell according to Claim 1, 2, 3 or 6, **characterised in that** the side of the semi-conductor element (1) is passified by a dielectric (9).

8. Solar cell according to one of Claims 1 to 7, **characterised in that** the semi-conductor element (1) comprises a succession of semi-conductor layers to establish a twosidedly light-sensitive solar cell, and the rear contact (6) is designed as a gridshaped contact system, and the solar cell is at its rear provided with an anti-reflex layer (31) and a cover glass (41).

9. Process for the manufacture of a solar cell according to one of Claims 1 to 7, **characterised by** the following procedural stages:
a) on a support substrate, a photo-active succession of layers for use as a solar cell is produced as a semi-conductor element;
b) onto the front light-incidence side of the semi-conductor element (1) are applied a gridshaped contact system (2) with connecting bars and an anti-reflex layer (3);
c) the front light-incidence side of the semi-conductor element (1) is, together with the contact system (2) and the anti-reflex layer (3), covered by a cover glass (4);
d) a support substrate and possibly present intermediate layers are in their entirety or partially removed from the semi-conductor element (1);
e) the edges of the semi-conductor element (1) and, at the same time, two partial areas of the semi-conductor element (1) are removed to lay bare at least one portion of the front contact (2) and to produce a cutout for rear circuit point (81);
f) onto the rear of the semi-conductor element (1), which is entirely or partially freed from support substrate and, if appropriate, from intermediate layers, is applied the rear contact (6) which is isolated from the end of the semi-conductor element (1) by the cutout for the rear circuit points and extends up to the dielectric intermediate layer (5) located on the side of the cover glass (4) facing towards the semi-conductor element (1) or to a dielectric intermediate layer (5) located between cover glass (4) and semi-conductor element (1) where it establishes the rear contact.

10. Process according to Claim 9, **characterised in that** the ends of the semi-conductor elements (1) produced according to process stage e) are passified.

11. Process according to Claim 9, **characterised in that** the conventional CLEFT process is used for removing the support substrate and possibly present intermediate and epitaxy layers.

12. Process according to Claim 9, **characterised in that** the support substrate and possibly present intermediate and epitaxy layers are removed from the semi-conductor element (1) by means of lifting techniques via a chemical selectively etchable epitaxically grown intermediate layer.

13. Process according to Claim 9, **characterised by** an etching technique with etching off the carrier substrate and possibly present intermediate and epitaxy layers down to an epitaxically grown stop layer.

14. Process according to Claim 9, **characterised in that** the support substrate and possibly present intermediate layers are in their entirety or partially removed from the semi-conductor element (1) by lapping and/or polishing and/or etching entirely or virtually down to the photo-electrically active layer regions.

15. Process for the manufacture of a solar cell according to Claim 8 whilst carrying out the process stages of Claim 9, 10, 11, 12, 13 or 14, **characterised in that** onto the support substrate is applied an epitaxy layer succession which can be used as a bi-facial solar cell, and onto the rear, which is freed from support substrate and possibly present intermediate layers, is applied a gridshaped rear contact system (6) and an anti-reflex layer (31), and a cover glass (41) is placed on the rear of the solar cell.

16. Process according to Claim 9 or 15, **characterised in that** the cover glass (4, 41) is applied by means of a temperature-resistant cover-glass adhesive (5, 51).

17. Process according to Claim 9 or 15, **characterised by** directly fusing the cover glass (4,41) onto the solar cell.

## Revendications

1. Cellule photovoltaïque mince avec un élément semiconducteur formé de couches semiconductrices photoactives, qui présente sur sa face antérieure recevant la lumière un système de contacts en forme de grille en tant que contact de face antérieure et un verre (4, 41) de protection et, sur sa face postérieure un contact (6) de face postérieure, deux points de câblage pour relier des connecteurs (27) permettant de réaliser un montage série et/ou parallèle de cellules photovoltaïques d'un ensemble de plusieurs cellules photovoltaïques étant prévus, lesquels points de câblage sont reliés de manière électroconductrice l'un au contact de face antérieure et l'autre au contact de face postérieure, caractérisée par le fait que les points de câblage (8, 81) sont disposés sur la face postérieure du verre de protection (4) tournée vers l'élément semiconducteur (1), sur des bords en vis-à-vis de la région définie comme surface de cellule photovoltaïque, dans des zones exemptes d'élément semiconducteur (1) et par le fait que la face antérieure de l'élément semiconducteur présente une couche (3, 31) anti-reflets.

2. Cellule photovoltaïque selon la revendication 1, caractérisée par le fait que les points de câblage (8, 81) sont situés sur une couche (5) intermédiaire diélectrique entre le verre de protection (4) et l'élément (1) semiconducteur.

3. Cellule photovoltaïque selon la revendication 2, caractérisée par le fait que l'on utilise une couche d'adhésif (5) comme couche intermédiaire entre le verre de protection (4) et l'élément (1) semiconducteur.

4. Cellule photovoltaïque selon la revendication 2, caractérisée par la couche (3, 31) anti-reflets servant de couche intermédiaire.

5. Cellule photovoltaïque selon la revendication 1 ou 2, caractérisée par le fait que les liaisons électriques entre les contacts (2, 6) et les points de câblage (8, 81) concernés sont réalisées par des contacts à pont.

6. Cellule photovoltaïque selon la revendication 5, caractérisée par une couche isolante entre l'élément semiconducteur (1) et le contact à pont (62) qui relie le point de câblage (81) au contact (6) de face postérieure.

7. Cellule photovoltaïque selon la revendication 1, 2, 3 ou 6, caractérisée par le fait que la face frontale de l'élément semiconducteur (1) est passivée à l'aide d'un diélectrique (9).

8. Cellule photovoltaïque selon l'une des revendications 1 à 7, caractérisée par le fait que l'élément semiconducteur (1) présente une succession de couches semiconductrices qui forment une cellule photovoltaïque sensible sur deux faces, par le fait que le contact de face postérieure (6) est conformé en systèmes de contacts en forme de grille et par le fait que la cellule photovoltaïque est pourvue, sur sa face postérieure, d'une couche anti-reflets (31) et d'un verre de protection (41).

9. Procédé de fabrication d'une cellule photovoltaïque selon l'une des revendications 1 à 7, caractérisé par les étapes suivantes:
a) sur un substrat, on produit en tant qu'élément semiconducteur, une succession de couches photoactive utilisable comme cellule photovoltaïque,
b) on applique sur la face antérieure de l'élément semiconducteur (1) recevant la lumière un système de contacts (2) en forme de grille avec des barrettes de contact et une couche anti-reflets (3),
c) on couvre la face antérieure de l'élément semiconducteur (1), le système de contacts (2) et la couche anti-reflets (3) d'un verre de protection (4),
d) on élimine totalement ou partiellement le substrat et des couches intermédiaires éventuellement présentes de l'élément semiconducteur (1)
e) par un traitement on élimine les bords de l'élément semiconducteur (1) et simultanément deux zones partielles de l'élément semiconducteur (1) aux fins de dégager au moins une partie du contact de face antérieure (2) et de créer un évidement pour le point de câblage (81) côté face postérieure,
f) on applique sur la face postérieure de l'élément semiconducteur totalement ou partiellement débarrassée du substrat et de couches intermédiaires éventuellement présentes le contact de face postérieure (6), lequel contact s'étend à travers l'évidement pour le point de câblage côté face postérieure, en étant isolé vis-à-vis de la face frontale de l'élément semiconducteur (1), jusqu'à la face du verre de protection (4) tournée vers le semiconducteur (1) ou jusqu'à une couche intermédiaire (5) diélectrique située entre le verre de protection (4) et le semiconducteur (1) et forme à cet endroit le point de câblage (81) pour le contact de face postérieure.

10. Procédé selon la revendication 9, caractérisé par le fait que l'on passive les faces frontales du semiconducteur (1) fabriquées selon l'étape e) du procédé.

11. Procédé selon la revendication 9, caractérisé par le fait que l'on utilise le procédé CLEFT connu pour éliminer le substrat et des couches intermédiaires et des couches épitaxiales éventuellement présentes.

12. Procédé selon la revendication 9, caractérisé par le fait que l'on élimine le substrat et des couches intermédiaires et des couches épitaxiales éventuellement présentes de l'élément semiconducteur (1) par une technique de décollement utilisant une couche intermédiaire obtenue par croissance épitaxiale qui peut être attaquée de manière sélective par voie chimique.

13. Procédé selon la revendication 9, caractérisé par une technique d'attaque chimique avec attaque du substrat et des couches intermédiaires et épitaxiales éventuellement présentes jusqu'à une couche d'arrêt obtenue par croissance épitaxiale.

14. Procédé selon la revendication 9, caractérisé par le fait que l'on élimine totalement ou partiellement le substrat et des couches intermédiaires éventuellement présentes de l'élément semiconducteur (1) par rabotage et/ou polissage et/ou attaque chimique jusqu'aux ou presque jusqu'aux zones actives du point de vue photoélectrique de la couche.

15. Procédé de fabrication d'une cellule photovoltaïque selon la revendication 8, utilisant les étapes suivantes de procédé selon les revendications 9, 10, 11, 12, 13 ou 14, caractérisé par le fait que l'on applique sur le substrat une succession de couches épitaxiales utilisable comme cellule photovoltaïque bi-face, que l'on applique sur la face postérieure débarrassée du substrat et des couches intermédiaires éventuellement présentes un système de contacts (6) postérieurs en forme de grille et une couche anti-reflets (31) et par le fait que l'on applique sur la face postérieure de la cellule photovoltaïque un verre de protection (41).

16. Procédé selon la revendication 9 ou 15, caractérisé par le fait que l'on fixe le verre (4, 41) à l'aide d'un adhésif (5, 51) résistant à la chaleur.

17. Procédé selon la revendication 9 ou 15, caractérisé par la coulée directe du verre de protection (4, 41) sur la cellule photovoltaïque.
